# NEW EUROPEAN PATENT SPECIFICATION

(11) **EP 0 149 533 B2**
(45) Date of publication and mention of the opposition decision: **15.12.1999**
(45) Mention of the grant of the patent: 05.09.1990
(21) Application number: 85300176.6
(22) Date of filing: 10.01.1985
(51) Int. Cl.: H03D 7/16, H04B 1/26

(54) **Apparatus for receiving super high frequency signals**
Gerät zum Empfang von Signalen superhoher Frequenz
Appareil pour la réception de signaux SHF

(30) Priority: 13.01.1984 JP 539184
(43) Date of publication of application: 24.07.1985
(73) Proprietor: SONY CORPORATION, Tokyo 141 (JP)
(72) Inventor: Ouchi, Koji c/o Patent Division, Shinagawa-ku Tokyo (JP); Tsurumaru, Shinobu Patent Division, Shinagawa-ku Tokyo (JP); Kajiwara, Tadashi Patent Division, Shinagawa-ku Tokyo (JP); Kumamoto, Kenichiro Patent Division, Shinagawa-ku Tokyo (JP)
(74) Representative: Cotter, Ivan John

(56) References cited:
- DE-A- 2 226 837
- GB-A- 1 359 752
- US-A- 2 460 900
- RADIO AND ELECTRONIC ENGINEER, vol. 52, no. 3, March 1982, pages 127-133, Institution of Electronic and Radio Engineers, London, GB; K.G. FREEMAN: "Direct broadcast satellite receivers"
- N.E.C. RESEARCH & DEVELOPMENT, no. 69, April 1983, pages 36-42, Tokyo, JP; H. YOSHIDA et al.: "12GHz broadcasting satellite receiver"
- IEEE INTERNATIONAL CONFERENCE ON COMMUNICATIONS, CONFERENCE RECORD, Boston, Massachusetts, 19th-22nd June 1983, vol. 1 of 3, pages 39-44, IEEE, US; T. BERCELI et al.: "A multiple-channel 12 GHz receiver for satellite television broadcasting"
- D.B. Spencer and K.G. Freeman: "Television Broadcasting from Satellites", published in "Wireless World", March 1974, pages 39-44;
- Dr. B. Liesenkötter and A. Ilsanker:"Polarisation-linear, zirkular", published in "Funkschau", vol. 19, 1982, pages 61-64.

## Description

This invention relates to apparatus for receiving super high frequency (SHF) signals. Such apparatus may form an SHF receiver for receiving SHF broadcast signals from, for example, a broadcast satellite.

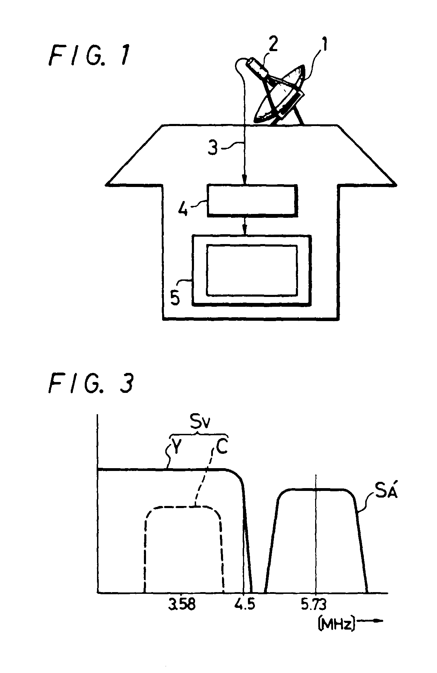

Generally, as shown, for example, in Figure 1 of the accompanying drawings, an SHF receiver for receiving an SHF broadcast signal from a broadcast satellite (not shown) comprises an antenna 1, an outdoor unit 2 installed on the outside of a house together with the antenna 1 to frequency-convert an electrical wave of an SHF band that is received by the antenna 1 to an electrical wave of an ultra high frequency (UHF) band and to amplify it, a coaxial cable 3, and an indoor unit 4 and a television receiver 5 installed inside the house. The indoor unit 4 is supplied with the signal that is frequency-converted to the UHF band signal from the outdoor unit 2 through the coaxial cable 3, and derives a video signal and an audio signal that are supplied to the television receiver 5.

An example of this kind of system is discussed in "Radio and Electronic Engineer", vol. 52, No. 3, March 1982, pages 127-133.

An SHF broadcast may, for example, be a low power broadcast (with a receiving frequency of 11.7 to 12.1 GHz) or a high power broadcast (with a receiving frequency of 12.2 to 12.7 GHz).

However, in the above SHF receiver, if the local oscillation frequency in the outdoor unit 2 is not changed over, the indoor unit 4 must accommodate a frequency band of 1000 MHz, and it is extremely difficult to realize a suitable circuit for the indoor unit 4.

Accordingly, in order to receive broadcasts in two difficult frequency bands using an indoor unit 4 of simple construction, the local oscillation frequency in the outdoor unit 2 must be changed over.

To change over the local oscillation frequency in the outdoor unit 2, it might be considered that in addition to the coaxial cable 3, there could be independently provided a local oscillation frequency control cable, that extended from the indoor unit 4 to the outdoor unit 2, and the switching of the local oscillation frequency could be controlled therethrough. However, it is undesirable that a plurality of cables be provided between the outdoor unit 2 and the indoor unit 4. Also, a plurality of cables would cause the number of terminals of the outdoor unit 2 to be increased, which makes sealing of the outdoor unit 2 to avoid the ingress of, for example, rainwater, more difficult.

According to the present invention there is provided apparatus for receiving super high frequency signals, the apparatus comprising: an outdoor unit comprising means for converting super high frequency signals to ultra high frequency signals and local oscillator means for generating a local signal which is supplied to said converting means; an indoor unit comprising means for demodulating said ultra high frequency signals; and cable means for supplying said ultra high frequency signals from said outdoor unit to said indoor unit and supplying a DC operating voltage from said indoor unit to said outdoor unit; characterised by: said outdoor unit further comprising means for switching the frequency of said local signal, and means for detecting said DC operating voltage which is supplied to said outdoor unit and the value of which is changed according to a band range of said super high frequency signals, the output of said detecting means controlling said switching means; and said indoor unit further comprising means for generating said DC operating voltage in dependence on the band range of said super high frequency signals.

The invention will now be described by way of example with reference to the accompanying drawings, throughout which like parts are referred to by like references and in which:
Figure 1 is a schematic diagram snowing an example of a previously proposed SHF receiver;
Figure 2 is a block diagram showing an embodiment of SHF receiver according to this invention; and
Figure 3 is a waveform diagram for explaining the embodiment.

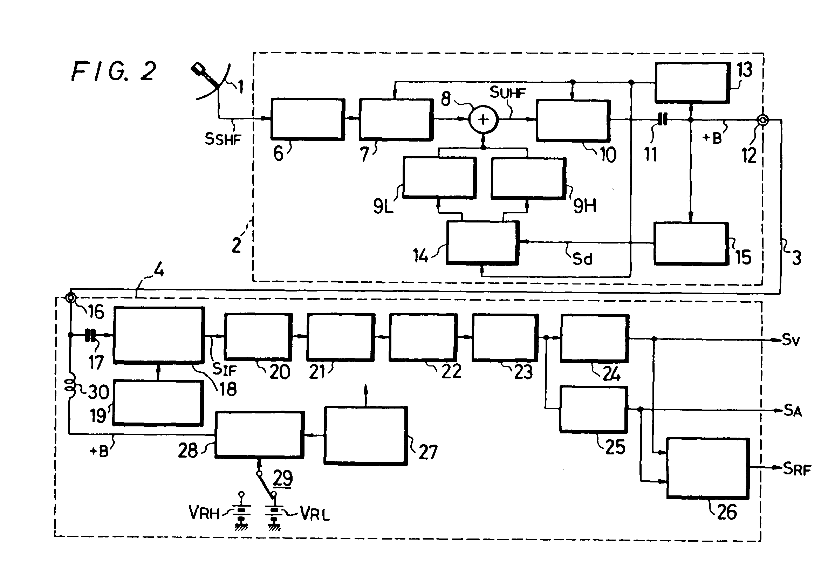

In the embodiment of Figure 2, an SHF broadcast signal S_{SHF} received by an antenna 1 is converted from a circularly polarized SHF signal to a linearly polarized SHF signal by a circuit-to-linear polarization wave converter 6 that is a part of an outdoor unit 2, and is then supplied through a high frequency amplifier 7 to a mixer 8.

Respective local oscillators 9L and 9H produce, for example, a frequency signal of 10.705 GHz (for receiving a low power broadcast) and a frequency signal of 11.2GHz (for receiving a high power broadcast). The frequency signals from the local oscillators 9L and 9H are respectively supplied to the mixer 8. The mixer 8 produces a signal S_{UHF} which has been frequency-converted to a UHF signal. The signal S_{UHF} is supplied through an intermediate frequency amplifier 10 and a capacitor 11 and for DC blocking to an output terminal 12.

A regulator 13 is supplied with a voltage +B that is supplied from an indoor unit 4 through a coaxial cable 3 to the terminal 12 and stabilizes the voltage +B. As will be mentioned later, the voltage +B that is supplied to the terminal 12 is made +10V or +15V respectively for receiving the low power broadcast (receiving frequency is 12.2 to 12.7 GHz). The voltage that is stabilized by the regulator 13 to be a predetermined voltage is supplied to the high frequency amplifier 7 and the intermediate frequency amplifier 10, and is also supplied through a switching circuit 14 to the local oscillators 9L and 9H.

A level detecting circuit 15 detects whether the voltage +B, that is supplied to the terminal 12 from the indoor unit 4, is +10V or +15V. A detected output signal Sd therefrom is supplied to the switching circuit 14 as a switching control signal. The switching circuit 14 is connected to the local oscillator 9L when the voltage +B is +10V, when receiving the low power broadcast (the receiving frequency is 11.7 to 12.2 GHz), while when the voltage +B is 15V, when receiving the high power broadcast (the receiving frequency is 12.2 to 12.7GHz), the switching circuit 14 is connected to the local oscillator 9H.

Accordingly, when receiving the low power broadcast, the operating voltage is supplied form the regulator 13 to the local oscillator 9L and the frequency signal of 10.705 GHz is supplied from the local oscillator 9L to the mixer 8. Thus the SHF receiver is set in the low power broadcast receiving mode. On the other hand, when receiving the high power broadcast, the operating voltage is supplied from the regulator 13 to the local oscillator 9H and the frequency signal of 11.2 GHz is supplied from the local oscillator 9H to the mixer 8. Thus the SHF receiver is set in the high power broadcast receiving mode.

The signal S_{UHF}, the frequency of which has been converted to that of the UHF band, and which is supplied to the terminal 12 of the outdoor unit 2, is supplied through the coaxial cable 3, an input terminal 16 and a DC blocking capacitor 17 to a tuner 18 that are a part of the indoor unit 4.

In the tuner 18, the broadcast of a predetermined channel is selected by the control of a channel selector 19 and an intermediate frequency (IF) frequency/modulated (FM) signal S_{IF} of the selected broadcast is produced at the output side of the tuner 18. This signal S_{IF} is supplied through a series circuit of an automatic gain control (AGC) amplifier 20, a band-pass filter 21 and a limiter 22 to an FM detector 23. From the FM detector 23 is derived a composite signal that consists of a video signal S_{V} formed of a luminance signal Y and a chrominance signal C, and an audio signal S_{A}' that is four-phase-shift keyed (4 PSK) as shown in, for example, Figure 3. This composite signal is supplied to a video amplifier 24 and an audio processor 25.

The video amplifier 24 produces the amplified video signal S_{V} and the audio processor 25 produces an audio signal S_{V}.

The video signal S_{V} from the video amplifier 24 and the audio signal S_{A} from the audio processor 25 are both supplied to a radio frequency (RF) converter 26, and the RF converter 26 produces a television signal S_{RF} that is matched with, for example, a vacant channel, and may be supplied to a monitor.

In the indoor unit 4, a voltage source circuit 27 supplies the required voltage to each section of the indoor unit 4 and a predetermined voltage to a regulator 28. Depending on reception of the low power broadcast or the high power broadcast, the regulator 27 is supplied with different reference voltage V_{RL} or V_{RH} through a switching circuit 29. Then, the regulator 28 produces at its output side the voltage +B of, for example +10V in receiving the lower power broadcast and the voltage +B of, for example, +15V in receiving the high power broadcast. This voltage +B is supplied through an AC blocking coil 30, the terminal 16 and the coaxial cable 3 to the terminal 12 of the outdoor unit 2 as described above.

Since the SHF receiver is constructed as described above, when receiving the low power broadcast (the receiving frequency is 11.7 to 12.2 GHz), the voltage +B that is supplied from the indoor unit 4 through the coaxial cable 3 to the terminal 12 of the outdoor unit 2 is made to be, for example +10V and the operating voltage is supplied to the local oscillator 9L by the control of the level detecting circuit 15 so that the frequency signal of 10.705 GHz is supplied from the local oscillator 9L to the mixer 8 and thus the outdoor unit 2 is set in the receiving mode for receiving the low power broadcast. On the other hand, when receiving the high power broadcast (the receiving frequency is 12.2 to 12.7 GHz), the voltage +B that is similarly supplied to the terminal 12 of the outdoor unit 2 is made to be, for example, +15V and the operating voltage is supplied to the local oscillator 9H by the control of the level detecting circuit 15 so that the frequency signal of 11.2 GHz is supplied from the local oscillator 9H to the mixer 8 and thus the outdoor unit 2 is set in the receiving mode for receiving the high power broadcast.

Thus, only the signal coaxial cable 3 need be provided between the outdoor unit 2 and the indoor unit 4, and it is nevertheless possible to change the receiving bands of the local oscillation frequency in the outdoor unit 2.

While in the above embodiment the local oscillators 9L and 9H are respectively changed over to switch the oscillation in the outdoor unit 2, it is possible that a single local oscillator is provided and its local oscillation frequency is changed over in accordance with the receiving band.

## Claims

1. Apparatus for receiving super high frequency signals, the apparatus comprising:
an outdoor unit (2) comprising means (8) for converting super high frequency signals to ultra high frequency signals and local oscillator means (9L, 9H) for generating a local signal which is supplied to said converting means (8);
an indoor unit (4) comprising means (23) for demodulating said ultra high frequency signals having a tuner (18) supplied with said ultra high frequency signals, a channel selector (19) for selecting a channel of said ultra high frequency signals, said channel selector (19) controlling the channel selection in said tuner (18); and
cable means (3) for supplying said ultra high frequency signals from said outdoor unit (2) to said indoor unit (4) and supplying a DC operating voltage from said indoor unit (4) to said outdoor unit (2);
characterised by:
said outdoor unit (2) further comprising means (14) for switching the frequency of said local signal, and means (15) for detecting said DC operating voltage which is supplied to said outdoor unit (2) and the value of which is changed according to a band range of said super high frequency signals, the output of said detecting means (15) controlling said switching means (14);
local oscillator means (9L, 9H) comprising first and second local oscillators (9L, 9H) having different frequencies, an output signal of either or said oscillators (9L, 9H) being selectively supplied to said converting means (8); and
said indoor unit (4) further comprising means (29) for generating said DC operating voltage in dependence on the band range of said super high frequency signals.

2. Apparatus according to claim 1 wherein said outdoor unit (2) further comprises a regulator (13) for stabilizing said DC operating voltage, the output of said regulator (13) being selectively supplied to either of said oscillators (9L, 9H) by said switching means (14).

3. Apparatus according to claim I wherein said local oscillator means is a variable frequency oscillator, whose frequency is varied by said switching means (14).

4. Apparatus according to claim 1 wherein said converting means (8) comprises a converter (6) for converting circularly polarized super high frequency signals to linearly polarized super high frequency signals, an amplifier (7) supplied with said linearly polarized super high frequency signals, and a mixer (8) supplied with the output of said amplifier (7) and said local signal, said mixer (8) producing said ultra high frequency signals, and said demodulating means (23) further comprises a detector (23) for detecting the output signal of said tuner (18), and means (24, 25, 26) for processing the output signal of said detector (23), said processing means (24, 25, 26) producing a video signal and an audio signal, respectively.

5. Apparatus according to claim 4 further comprising antenna means (1) for supplying said circularly polarized super high frequency signals received thereat to said converter (6).

6. Apparatus according to claim 5 further comprising monitor means supplied with said video signal and said audio signal.

## Patentansprüche

1. Gerät für den Empfang von Zentimeterwellensignalen (SHF-Signalen)
mit einer Außenraum-Einheit (2), die eine Umsetzereinrichtung (8) zum Umsetzen von SHF-Signalen in Dezimeterwellensignale (UHF-Signale) aufweist sowie eine lokale Oszillatoreinrichtung (9L, 9H) zur Erzeugung eines lokalen Signals, das der Umsetzereinrichtung (8) zugeführt wird,
mit einer Innenraum-Einheit (4), die eine Demodulatoreinrichtung (23) zum Demodulieren der UHF-Signale aufweist, ferner einen Tuner (18), dem die UHF-Signale zugeführt werden, sowie einen Kanalwähler (19) zum Auswählen eines Kanals der UHF-Signale, wobei der Kanalwähler (19) die Kanalwahl in dem Tuner (18) steuert,
sowie mit einer Kabelanordnung (3) zum Zuführen der UHF-Signale von der Außenraum-Einheit (2) zu der Innenraum-Einheit (4) und zum Zuführen einer Gleich-Betriebsspannung von der Innenraum-Einheit (4) zu der Außenraum-Einheit (2),
**dadurch gekennzeichnet,**
daß die Außenraum-Einheit (2) ferner eine Schalteinrichtung (14) zum Umschalten der Frequenz des lokalen Signals aufweist sowie eine Detektoreinrichtung (15) zum Detektieren der der Außenraum-Einheit (2) zugeführten Gleich-Betriebsspannung, deren Wert nach Maßgabe des Frequenzbandbereichs der SHF-Signale geändert wird, wobei das Ausgangssignal der Detektoreinrichtung (15) die genannte Schalteinrichtung (14) steuert,
daß die lokale Oszillatoreinrichtung (9L, 9H) einen ersten und einen zweiten lokalen Oszillator (9L, 9H) aufweist, die unterschiedliche Frequenzen haben, wobei wahlweise ein Ausgangssignal eines dieser Oszillatoren (9L, 9H) der Wandlereinrichtung (8) zugeführt wird,
und daß die Innenraum-Einheit (4) ferner Mittel (29) zur Erzeugung der Gleich-Betriebsspannung in Abhängigkeit von dem Frequenzbandbereich der SHF-Signale aufweist.

2. Gerät nach Anspruch 1, bei dem die Außenraum-Einheit (2) ferner einen Regler (13) zur Stabilisierung der Gleich-Betriebsspannung aufweist, dessen Ausgangssignal von den genannten Schaltmitteln (14) selektiv einem der beiden Oszillatoren (9L, 9H) zugeführt wird.

3. Gerät nach Anspruch 1, bei dem die lokale Oszillatoreinrichtung ein Oszillator mit variabler Frequenz ist, dessen Frequenz durch die genannten Schaltmittel (14) veränderbar ist.

4. Gerät nach Anspruch 1,
bei dem die Umsetzerereinrichtung (8) einen Konverter (6) zur Umwandlung von zirkular polarisierten SHF-Signalen in linear polarisierte SHF-Signale aufweist, ferner einen Verstärker (7), dem diese linear polarisierten SHF-Signale zugeführt werden, und einen Mischer (8), dem das Ausgangssignal des Verstärkers (7) und das lokalen Signal zugeführt werden und der die UHF-Signale erzeugt,
und bei dem die Demodulatoreinrichtung (23) ferner einen Detektor (23) aufweist zum Detektieren des Ausgangssignals des Tuners (18) sowie Mittel (24, 25, 26) zur Verarbeitung des Ausgangssignals des Detektors (23), wobei diese Mittel (24, 25, 26) ein Videosignal bzw. ein Audiosignal erzeugen.

5. Gerät nach Anspruch 4, ferner mit einer Antennenanordnung (1) zum Zuführen der von ihr empfangenen zirkular polarisierten SHF-Signale dem Konverter (6).

6. Gerät nach Anspruch 5, ferner mit einer Monitoreinrichtung, der das Videosignal und das Audiosignal zugeführt werden.

## Revendications

1. Appareil permettant de recevoir des signaux d'hyperfréquence, l'appareil comprenant :
une unité externe (2) comprenant un moyen (8) servant à convertir des signaux d'hyperfréquence en signaux d'ultra-haute fréquencc et un moyen faisant fonction d'oscillateur local (9L, 9H) servant à produire un signal local qui est fourni audit moyen de conversion (8) ;
une unité interne (4) comprenant un moyen (23) servant à démoduler lesdits signaux d'ultra-haute fréquence, qui possède un syntoniseur (18) recevant lesdits signaux d'ultra-haute fréquence, un sélecteur de canal (19) servant à sélectionner un canal desdits signaux d'ultra-haute fréquence, ledit sélecteur de canal (19) commandant la sélection du canal dans ledit syntoniseur (18) ; et
un moyen faisant fonction de câble (3) servant à délivrer lesdits signaux d'ultra-haute fréquence de ladite unité externe (2) à ladite unité interne (4) et à délivrer une tension continue de fonctionnement de ladite unité interne (4) à ladite unité externe (2) ;
caractérisé en ce que :
ladite unité externe (2) comprend en outre un moyen (14) servant à faire commuter la fréquence dudit signal local, et un moyen (15) servant à détecter ladite tension continue de fonctionnement qui est fournie à ladite unité externe (2) et dont la valeur est modifiée en fonction d'un intervalle de bande desdits signaux d'hyperfréquence, le signal de sortie dudit moyen de détection (15) commandant ledit moyen de commutation (14) ;
le moyen faisant fonction d'oscillateur local (9L, 9H) comprend des premier et deuxième oscillateurs locaux (9L, 9H) ayant des fréquences différentes. le signal de sortie de l'un desdits oscillateurs (9L. 9H) étant sélectivement délivré audit moyen de conversion (8) ; et
ladite unité interne (4) comprend en outre un moyen (29) servant à produire ladite tension continue de fonctionnement en fonction de l'intervalle de bande desdits signaux d'hyperfréquence.

2. Appareil selon la revendication 1, où ladite unité externe (2) comprend en outre un régulateur (13) servant à stabiliser ladite tension continue de fonctionnement le signal de sortie dudit régulateur (13) étant sélectivement délivré à un desdits oscillateurs (9L, 9H) par ledit moyen de commutation (14),

3. Appareil selon la revendication 1, où ledit moyen faisant fonction d'oscillateur local est un oscillateur à fréquence variable, dont on fait varier la fréquence à l'aide dudit moyen de commutation (14).

4. Appareil selon la revendication 1, où ledit moyen de conversion (8) comprend un convertisseur (6) servant à convertir des signaux d'hyperfréquence circulairement polarisés en signaux d'hyperfréquence linéairement polarisés, un amplificateur (7) recevant lesdits signaux d'hyperfréquence linéairement polarisés, et un mélangeur (8) recevant le signal de sortie dudit amplificateur (7) et ledit signal local, ledit mélangeur (8) produisant lesdits signaux d'ultra-haute fréquence, et ledit moyen de démodulation (23) comprend en outre un détecteur (23) servant à détecter le signal de sortie dudit syntoniseur (18), et un moyen (24, 25, 26) servant à traiter le signal de sortie dudit détecteur (23), ledit moyen de traitement (24, 25, 26) produisant respectivement un signal vidéo et un signal audio.

5. Appareil selon la revendication 4, comprenant en outre un moyen (1) faisant fonction d'antenne servant à délivrer audit convertisseur (6) lesdits signaux d'hyperfréquence circulairement polarisés qu'il reçoit.

6. Appareil selon la revendication 5, comprenant en outre un moyen faisant fonction d'écran de contrôle qui reçoit ledit signal vidéo et ledit signal audio.
